# EUROPEAN PATENT APPLICATION

(11) **EP 4 535 387 A1**
(43) Date of publication of application: **09.04.2025**
(21) Application number: 23816100.4
(22) Date of filing: 31.05.2023
(51) Int. Cl.: H01G 9/07, H01G 4/30, H01G 4/33, H01G 9/042, H01G 9/15

(54) **CAPACITOR, ELECTRIC CIRCUIT, CIRCUIT BOARD, DEVICE, AND METHOD FOR MANUFACTURING CAPACITOR**

(30) Priority: 01.06.2022 JP 2022089924
(71) Applicant: Panasonic Intellectual Property Management Co., Ltd., Kadoma-shi, Osaka 571-0057 (JP)
(72) Inventor: GOTO, Takehito, Osaka 571-0057 (JP); KITAMURA, Naoya, Osaka 571-0057 (JP); KANOU, Manabu, Osaka 571-0057 (JP); KIKUCHI, Ryosuke, Osaka 571-0057 (JP)
(74) Representative: Eisenführ Speiser
(86) International application number: PCT/JP2023/020267
(87) International publication number: WO 2023/234343

(57) **Abstract**

A capacitor 1a includes a metallic tantalum 10, an electric conductor 20, and an oxidized tantalum film 30. The oxidized tantalum film 30 is disposed between the metallic tantalum 10 and the electric conductor 20, where the oxidized tantalum film 30 is in contact with the metallic tantalum 10. The oxidized tantalum film 30 includes a first portion 31 containing fluorine, and a second portion 32. The second portion 32 is located closer to the metallic tantalum 10 than the first portion 31 in a thickness direction of the oxidized tantalum film 30. And a fluorine concentration at the second portion 32 is lower than a fluorine concentration at the first portion 31.

## Description

### TECHNICAL FIELD

The present disclosure relates to a capacitor, an electric circuit, a circuit board, an apparatus, and a method for manufacturing a capacitor.

### BACKGROUND ART

It has been known that oxidized tantalum containing fluorine is used for capacitors.

For example, Patent Literature 1 describes a solid electrolytic capacitor including a dielectric layer formed of oxidized tantalum containing fluorine. The dielectric layer is formed by anodic oxidation of an anode formed of tantalum in an aqueous solution containing fluorine ions.

Non Patent Literature 1 describes polycrystalline TaO₂F thin film with a relative permittivity of 60 at 1 MHz.

### CITATION LIST

### Patent Literature

Patent Literature 1: JP 2005-294402 A

### Non Patent Literature

Non Patent Literature 1: Journal of Materials Chemistry C, (UK), 2020, Issue 14, p.4680-4684

### SUMMARY OF INVENTION

### Technical Problem

The present disclosure provides a capacitor where a fluorine-containing tantalum oxide is used, the capacitor is advantageous from the viewpoint of reducing dielectric loss tangent.

### Solution to Problem

A capacitor of the present disclosure includes:
metallic tantalum;
an electric conductor; and
an oxidized tantalum film disposed between the metallic tantalum and the electric conductor, the oxidized tantalum film being in contact with the metallic tantalum, wherein
the oxidized tantalum film includes a first portion containing fluorine and a second portion located closer to the metallic tantalum than the first portion in a thickness direction of the oxidized tantalum film, and
a fluorine concentration at the second portion is lower than a fluorine concentration at the first portion.

### Advantageous Effects of Invention

According to the present disclosure, it is possible to provide a capacitor where a fluorine-containing tantalum oxide is used, the capacitor is advantageous from the viewpoint of reducing dielectric loss tangent.

### BRIEF DESCRIPTION OF DRAWINGS

FIG. 1 is a cross-sectional view showing an example of a capacitor of the present disclosure.
FIG. 2 is a flowchart showing an example of a method for manufacturing a capacitor of the present disclosure.
FIG. 3 is a cross-sectional view showing another example of a capacitor of the present disclosure.
FIG. 4A is a schematic view showing an example of an electric circuit of the present disclosure.
FIG. 4B is a schematic view showing an example of a circuit board of the present disclosure.
FIG. 4C is a schematic view showing an example of an apparatus in the present disclosure.
FIG. 5 is a graph showing an XRD pattern of a dielectric film of a sample according to Example 1.
FIG. 6 is a graph showing a relation between signal intensity of F⁻, TaO³⁻, and O⁻in time-of-flight secondary ion mass spectrometry (TOF-SIMS) and depth in a dielectric film of the sample according to Example 1.
FIG. 7 is a graph showing a relation between signal intensity of F⁻, TaO³⁻, and O⁻in TOF-SIMS of the oxidized tantalum film and the depth in the dielectric film of a sample according to Comparative Example 1.
FIG. 8A is a graph showing a relation between capacitance and frequency of an exemplified capacitor.
FIG. 8B is a graph showing a relation between capacitance and frequency of an exemplified capacitor.
FIG. 9A is a graph showing a relation between dielectric loss tangent tanδ and frequency of an exemplified capacitor.
FIG. 9B is a graph showing a relation between dielectric loss tangent tanδ and frequency of an exemplified capacitor.

### DESCRIPTION OF EMBODIMENTS

### (Findings on which the present disclosure is based)

For example, there is a continuous need to improve process performance of an electronic apparatus. Performance of electronic components such as a capacitor has a significant impact on the performance of the electronic apparatus in which the components are incorporated. Therefore, it is expected that there will be an increasing need for capacitors that are small in size and capable of exhibiting high performance. An example of known capacitor is an electrolytic capacitor. In the electrolytic capacitor, a dielectric of an oxidized thin film is formed on a surface of metallic aluminum or metallic tantalum by chemical conversion treatment of aluminum or tantalum. As to such an electrolytic capacitor, attempts have been made to increase capacitance of the capacitor mainly by increasing the specific surface area of the dielectric. In the meantime, since such attempts have limitations, seemingly the capacitor performance would be further improved by developing dielectrics with higher dielectric constants.

For example, a polycrystalline TaO₂F thin film described in Non Patent Literature 1 has a high relative permittivity. It is believed that polycrystal of tantalum oxyfluoride has a crystal state different from that of tantalum oxide Ta₂O₅, and hence, has a large polarization, and has a high relative dielectric constant. The present inventors have further found through their investigation that fluorine-containing tantalum oxide has a higher relative permittivity than fluorine-free tantalum oxideTa₂O₅ even in the case where the tantalum oxide is amorphous. From these results, it is expected that capacitance of the capacitor will be increased by use of fluorine-containing tantalum oxide in the capacitor. In the meantime, the investigation of the inventors has revealed that in a capacitor including a film of fluorine-containing tantalum oxide, a phenomenon that the dielectric loss tangent of the film increases may occur. It is advantageous that the dielectric loss tangent of the dielectric is lowered in order to reduce the loss of electrical energy in the capacitor.

According to Patent Literature 1, the dielectric layer is formed by anodic oxidation of an anode formed of tantalum, in an aqueous solution containing fluorine ions. It is reported that an equivalent series resistance (ESR) of an electrolytic capacitor is reduced by use of a dielectric layer made of oxidized tantalum containing fluorine. In the meantime, according to an investigation of the present inventors, it has been found that there are certain conditions under which the dielectric loss tangent of the film obtained by the anodic oxidation of tantalum in an aqueous solution containing fluorine ions becomes high. It has been found that in such films, fluorine gathers at the interface between the tantalum oxide and elemental tantalum, forming regions of high fluorine concentration. The reason may be as follows. The ionic diffusion rate of fluoride ions is twice or more the ionic diffusion rate of oxide ions, and thus, depending on the anodic oxidation conditions, fluorine may gather at the interface between the tantalum oxide and the elemental tantalum to form a region where the fluorine concentration is high. Due to the formation of a region of high fluorine concentration at the interface between the tantalum oxide and the elemental tantalum, the dielectric loss tangent of the film may be increased.

In view of these circumstances, the present inventors have diligently investigated a capacitor capable of reducing dielectric loss tangent, where fluorine-containing tantalum oxide is used in the capacitor. As a result, it was newly discovered that a film of a tantalum oxide with a specific structure is advantageous for reducing the dielectric loss tangent. The present inventors have completed the capacitor of the present disclosure based on this new knowledge.

### (Summary of an aspect according to the present disclosure)

A capacitor according to a first aspect of the present disclosure includes:
metallic tantalum;
an electric conductor; and
an oxidized tantalum film disposed between the metallic tantalum and the electric conductor, the oxidized tantalum film being in contact with the metallic tantalum, wherein
the oxidized tantalum film includes a first portion containing fluorine and a second portion located closer to the metallic tantalum than the first portion in a thickness direction of the oxidized tantalum film, and
a fluorine concentration at the second portion is lower than a fluorine concentration at the first portion.

According to a first aspect, the fluorine concentration in the vicinity of the metallic tantalum of the oxidized tantalum film is less likely to be increased. Therefore, the dielectric loss tangent of the capacitor is likely to be lowed, even though the oxidized tantalum film includes a first portion that contains fluorine.

In a second aspect of the present disclosure, for example, in the capacitor according to the first aspect, the first portion may be amorphous. According to the second aspect, the capacitor has a high capacitance while the capacitor is capable of preventing current leakage caused by a crystalline phase.

In a third aspect of the present disclosure, for example, in the capacitor according to the first or second aspect, the first portion may have a composition represented by TaOₓF_{y}, and the composition may satisfy a requirement 0 < x < 2.5. In this case, the oxidized tantalum film is more likely to have a high relative permittivity, and thus, the capacitor is more likely to have a high capacitance.

In a fourth aspect of the present disclosure, for example, in the capacitor according to the third aspect, the composition may further satisfy a requirement y ≥ 0.015. In this case, the oxidized tantalum film is more likely to have a high relative permittivity and thus, the capacitor is more likely to have a high capacitance.

In a fifth aspect of the present disclosure, for example, in the capacitor according to the fourth aspect, the composition may further satisfy a requirement y ≤ 0.40. In this case, the fluorine contained in the oxidized tantalum film is prevented easily from diffusing toward the metallic tantalum due to the influences of electric field, heat or the like, and thus, the oxidized tantalum film is less likely to be degraded. Therefore, the performance of the capacitor is likely to be stabilized.

In a sixth aspect of the present disclosure, for example, in the capacitor according to any one of the first to fifth aspects, the fluorine concentration at the second portion may be 0.4% or less on the basis of the number of atoms. According to the sixth aspect, the fluorine concentration in the vicinity of the metallic tantalum of the oxidized tantalum film is less likely to be increased and the dielectric loss tangent of the capacitor is more likely to be lowered.

In a seventh aspect of the present disclosure, for example, in the capacitor according to any one of the first to sixth aspects, the second portion may have a thickness of more than 5 nm and not more than 100 nm. According to the seventh aspect, the oxidized tantalum film is more likely to have a high relative permittivity and the capacitor is likely to have a high capacitance. In addition, since the thickness of the second portion is more than 5 nm, the fluorine may be prevented more easily from diffusing toward the metallic tantalum, and the dielectric loss tangent of the capacitor is more likely to be lowered. The thickness of a natural oxidized film to be formed on the surface of the metallic tantalum is usually about 5 nm.

In an eighth aspect of the present disclosure, for example, the capacitor according to any one of the first to seventh aspects may further include an electrolyte disposed between the oxidized tantalum film and the electric conductor. According to the eighth aspect, the capacitor can be configured as an electrolytic capacitor and the capacitor is likely to have a high capacitance.

An electric circuit according to a ninth aspect of the present disclosure includes the capacitor according to any one of the first to eighth aspects. According to the ninth aspect, the oxidized tantalum film of the capacitor includes a first portion containing fluorine, while the dielectric loss tangent of the capacitor is likely to be lowered, and thus, the electric circuit can easily exhibit desired performance.

A circuit board according to a tenth aspect of the present disclosure includes the capacitor according to any one of the first to eighth aspects. According to the tenth aspect, the oxidized tantalum film of the capacitor includes a first portion containing fluorine, while the dielectric loss tangent of the capacitor is likely to be lowered, and thus, the circuit board can easily exhibit desired performance.

An apparatus according to an eleventh aspect of the present disclosure includes the capacitor according to any one of the first to eighth aspects. According to the eleventh aspect, the oxidized tantalum film of the capacitor includes the first portion that contains fluoride, while the dielectric loss tangent of the capacitor is likely to be lowered and thus, the apparatus can easily exhibit desired performance.

A method for manufacturing a capacitor according to a twelfth aspect of the present disclosure includes: anodizing metallic tantalum in contact with a fluorine-free aqueous solution to form a tantalum oxide layer on the metallic tantalum; and anodizing the tantalum oxide layer in contact with a fluorine-containing aqueous solution to form a fluorine-containing oxidized tantalum film on a surface region of the tantalum oxide layer. According to the twelfth aspect, it is possible to manufacture a capacitor with a low dielectric loss tangent while the oxidized tantalum film includes a fluorine-containing portion.

### (Embodiments)

Embodiments of the present disclosure will be described below with reference to the attached drawings. The present disclosure is not limited to the following embodiments.

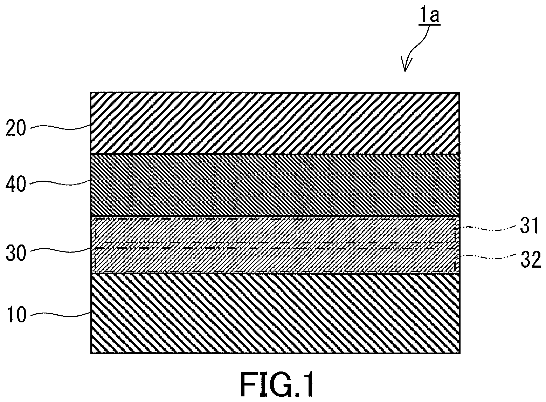

FIG. 1 is a cross-sectional view showing an example of a capacitor of the present disclosure. As shown in FIG. 1, a capacitor 1a includes a metallic tantalum 10, an electric conductor 20, and an oxidized tantalum film 30. The oxidized tantalum film 30 is disposed between the metallic tantalum 10 and the electric conductor 20, being in contact with the metallic tantalum 10. The oxidized tantalum film 30 includes a stratiform first portion 31 that contains fluorine and a stratiform second portion 32. The first portion 31 corresponds to a region on the surface of the oxidized tantalum film 30 in the thickness direction of the oxidized tantalum film 30 (surface region). The second portion 32 is located closer to the metallic tantalum 10 than the first portion 31 in the thickness direction of the oxidized tantalum film 30. The fluorine concentration at the second portion 32 is lower than the fluorine concentration at the first portion 31.

The oxidized tantalum film 30 is likely to have a high relative permittivity, since the oxidized tantalum film 30 includes a stratiform first portion 31 that contains fluorine. As a result, the capacitor 1a is likely to have a high capacitance. Since the oxidized tantalum film 30 has a stratiform second portion 32 at a location closer to the metallic tantalum 10 than the first portion 31, and the second portion 32 has a lower fluorine concentration, the fluorine concentration is unlikely to become high at the interface between the oxidized tantalum film 30 and the metallic tantalum 10. Therefore, the dielectric loss tangent of the capacitor 1a is likely to be lowed.

The dielectric loss tangent of capacitor 1a is, for example, 0.20 or less at frequencies from 1 Hz to 10 kHz.

The boundary between the first portion 31 and another portion in the oxidized tantalum film 30 may form an interface that is visible, for example, when observing a cross section of the oxidized tantalum film 30 taken along the thickness direction with a scanning electron microscope (SEM) or a transmission electron microscope (TEM). The boundary between the first portion 31 and the other portions in the oxidized tantalum film 30 may be virtual, and the interface between the first portion 31 and the other portions may be invisible when observing the cross section taken along the thickness direction of the oxidized tantalum film 30 with SEM or TEM. The boundary between the second portion 32 and other moieties in the oxidized tantalum film 30 may provide a visible interface, for example, when observing the cross section taken along the thickness direction of the oxidized tantalum film 30 with SEM or TEM. The boundary between the second portion 32 and other portions in the oxidized tantalum film 30 may be virtual, and the interface between the second portion 32 and the other portion may be invisible when observing the cross section of the oxidized tantalum film 30 along the thickness direction with SEM or TEM.

The location of the first portion 31 is not limited to a particular location as long as the second portion 32 is located closer to the metallic tantalum 10 than the first portion 31 in the thickness direction of the oxidized tantalum film 30. The first portion 31 is present, for example, at a location corresponding to a depth of 100 nm or less from the main surface closest to the electric conductor 20 in the thickness direction of the oxidized tantalum film 30.

The first portion 31 may be crystalline or amorphous. Even when the first portion 31 is amorphous, the oxidized tantalum film 30 is likely to have a high relative permittivity, and the capacitor 1a is likely to have a high capacitance. For example, in the case where a broad halo pattern is shown in an XRD pattern of the object using Cu-Kα radiation at a diffraction angle 2θ of 10° to 50°, the object can be determined to be amorphous.

The second portion 32 may be crystalline or amorphous.

The composition of the first portion 31 is not limited to a particular composition as long as the fluorine concentration at the second portion 32 is lower than the fluorine concentration at the first portion 31. The first portion 31 is free of silicon and titanium, for example. The first portion 31 has a composition represented by TaOₓF_{y}, for example. This composition satisfies a requirement 0 < x < 2.5, for example. In this case, the oxidized tantalum film 30 is likely to have a high relative permittivity, and the capacitor 1a is likely to have a high capacitance.

In the above composition, for example, a requirement y ≥ 0.015 is satisfied. In this case, the oxidized tantalum film 30 is more likely to have a high relative permittivity and the capacitor 1a is more likely to have a high capacitance. In the above composition, requirements y ≥ 0.016, y ≥ 0.017, y ≥ 0.018, y ≥ 0.019, y ≥ 0.02, y ≥ 0.03, y ≥ 0.05, or y ≥ 0.1 may be satisfied, y ≥ 0.2 may be satisfied, or y ≥ 0.3 may be satisfied. The above composition may also satisfy requirements 0 < x < 2.5 and 0 < y < 0.015.

In the above composition, for example, a requirement y ≤ 0.40 may be further satisfied. In this case, the fluorine contained in the oxidized tantalum film 30 is easily prevented from diffusing toward the metallic tantalum 10, where the diffusion may be caused by the influence of electric field, heat or the like, and the oxidized tantalum film 30 is resistant to deterioration. In the above composition, a requirement 0 < y ≤ 0.40, 0 < y < 0.40, or 0.015 ≤ y ≤ 0.40 may be satisfied.

As long as the fluorine concentration at the second portion 32 is lower than the fluorine concentration at the first portion 31, the fluorine concentration at the second portion 32 is not limited to a specific value. The fluorine concentration at the second portion 32 is 0.4% or less, for example, on the basis of the number of atoms. In other words, the ratio of the number of fluorine atoms to the total number of atoms included in the second portion 32 is 0.4% or less. In this case, the fluorine concentration in the vicinity of the metallic tantalum 10 in the oxidized tantalum film 30 is less likely to be increased, and the dielectric loss tangent of the capacitor 1a is more likely to be lowed. The fluorine concentration at the second portion 32 can be determined based on, for example, TOF-SIMS results. TOF-SIMS may be combined with another analytical technique, such as Rutherford backscattering spectroscopy (RBS), to determine the fluorine concentration at the second portion 32.

The fluorine concentration at the second portion 32 may be 0.3% or less, 0.2% or less, or 0.1% or less, may be 0.05% or less, or may be 0.01% or less, on the basis of the number of atoms.

The F⁻ signal intensity ratio (R_{F}) of the oxidized tantalum film 30 in TOF-SIMS is not limited to a specific value. The signal intensity ratio R_{F} is the ratio of the second signal intensity R_{F2} to the first signal intensity R_{F1}. The first signal intensity R_{F1} is the signal intensity of F⁻ at a depth corresponding to the first portion 31 of TOF-SIMS in the oxidized tantalum film 30. The second signal intensity R_{F2} is the signal intensity of F⁻ at a depth corresponding to the second portion 32 of the TOF-SIMS of the oxidized tantalum film 30. The signal intensity ratio R_{F} is 0.0026 or more, for example. In this case, the fluorine concentration in the vicinity of the metallic tantalum 10 of the oxidized tantalum film 30 is less likely to be increased, and the dielectric loss tangent of the capacitor 1a is more likely to be lowered. The signal intensity ratio R_{F} may be 0.005 or more, may be 0.01 or more, or may be 0.05 or more. The signal intensity ratio R_{F} is, for example, 0.1 or less.

The thickness of the second portion 32 is not limited to a specific value. The thickness is, for example, 100 nm or less. In this case, the thickness of the second portion 32 may account for a low proportion of the total thickness of the oxidized tantalum film 30. Since the fluorine concentration at the second portion 32 is lower than the fluorine concentration at the first portion 31, the second portion 32 is less likely to have a high relative permittivity. Therefore, when the thickness of the second portion 32 accounts for a low proportion of the total thickness of the oxidized tantalum film 30, the entire relative permittivity of the oxidized tantalum film 30 is likely to be increased and the capacitor 1a may easily have a high capacitance.

The thickness of the second portion 32 may be more than 5 nm and not more than 100 nm. As described above, when the thickness of the second portion 32 is 100 nm or less, the entire relative permittivity of the oxidized tantalum film 30 is likely to increase, and the capacitor 1a is likely to have a high capacitance. When the thickness of the second portion 32 is more than 5 nm, the fluorine may be prevented more easily from diffusing toward the metallic tantalum 10 in the oxidized tantalum film 30, and the dielectric loss tangent of the capacitor 1a is likely to be lowered.

The thickness of the second portion 32 may be 11 nm or more, may be 12 nm or more, may be 15 nm or more, or may be 20 nm or more. The thickness of the second portion 32 may be 90 nm or less, may be 80 nm or less, or may be 70 nm or less. The thickness of the second portion 32 may fall within a predetermined range. The lower limit of that range is, for example, selected from the group consisting of 5 nm, 7 nm, 12 nm, 15 nm, and 20 nm. The upper limit of the range is, for example, selected from the group consisting of 70 nm, 80 nm, 90 nm, and 100 nm. In the case where 5 nm is selected as the lower limit value, it means that the thickness of the second portion 32 is more than 5 nm. In the case where a value other than 5 nm is selected as the lower limit value, it means that the thickness of the second portion 32 is not lower than the selected value. This means that the thickness of the second portion 32 is not more than the selected upper limit.

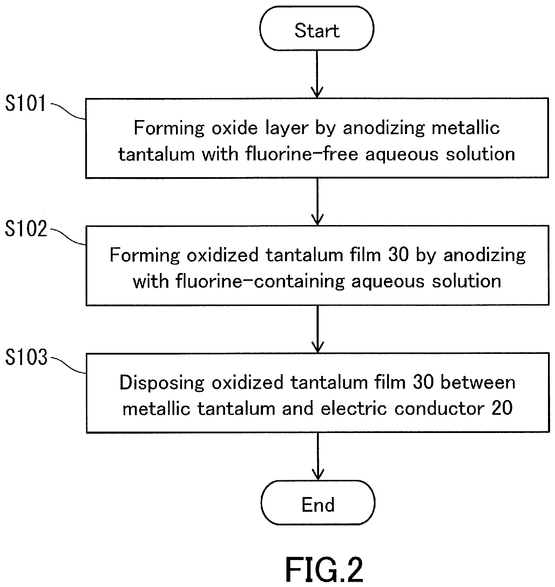

The method for manufacturing the capacitor 1a is not limited to a particular method. FIG. 2 is a flowchart showing an example of a method for manufacturing the capacitor 1a. The capacitor 1a is formed, for example, by a method including the following (I) and (II).
(I) Anodization is performed on metallic tantalum while allowing the metallic tantalum to be in contact with a fluorine-free aqueous solution, thereby forming a tantalum oxide layer on the metallic tantalum. In other words, a tantalum oxide layer in contact with the metallic tantalum is formed (step S101 in FIG. 2).
(II) Anodization is performed on the metallic tantalum while allowing the tantalum oxide layer formed in the above (I) to be in contact with a fluorine-containing aqueous solution, thereby forming an oxidized tantalum film 30 including a first portion 31 containing fluorine and a second portion 32 (step S102 in FIG. 2).

During the anodization, for example, a voltage of several volts to several hundred volts is applied between an anode and a cathode in the state where an electrolyte is disposed between the anode and the cathode. In the case where the metallic tantalum is an anode, anions attracted to the metallic tantalum combine with ionized tantalum, whereby an anodized film is formed. In this process, ions or atoms as impurities derived from the electrolyte present together around the anode may be incorporated into the chemical film. Therefore, in anodization using the metallic tantalum as an anode, it is practically impossible to form a film consisting of only two specific elements such as tantalum and oxygen. Therefore, in the capacitor 1a, other elements such as fluorine at an impurity level may be included in the second portion 32. The impurity level means, for example, that elements such as fluorine other than tantalum and oxygen may be present in the second portion 32 in a concentration of 0.4% or less on the basis of the number of atoms.

Next, in a step S103, the oxidized tantalum film 30 is disposed between the metallic tantalum and the electric conductor 20. In other words, in the step S103, the electric conductor 20 is disposed to be closer to the oxidized tantalum film 30 than the metallic tantalum 10. For example, a capacitor 1a is obtained in this manner.

In the capacitor 1a, the electric conductor 20 is not limited to a particular material. The electric conductor 20 may include a valve metal such as aluminum, tantalum, niobium, bismuth or the like. Or the electric conductor 20 may include a noble metal such as gold, platinum or the like, or it may include nickel. The electric conductor 20 may include a carbon material such as graphite.

As shown in FIG. 1, the capacitor 1a includes, for example, an electrolyte 40. The electrolyte 40 is disposed between the oxidized tantalum film 30 and the electric conductor 20. In this case, the capacitor 1a is provided as an electrolytic capacitor. In the capacitor 1a, the electrolyte 40 forms, for example, a stratum. In the capacitor 1a, the electrolyte 40 may be omitted.

The electrolyte 40 is not limited to a particular electrolyte. The electrolyte 40 includes, for example, at least one selected from the group consisting of an electrolyte solution and an electrically conductive polymer. Examples of the electrically conductive polymer include polypyrrole, polythiophene, polyaniline, and a derivative thereof. The electrolyte 40 may be a manganese compound, such as manganese oxide. The electrolyte 40 may include a solid electrolyte.

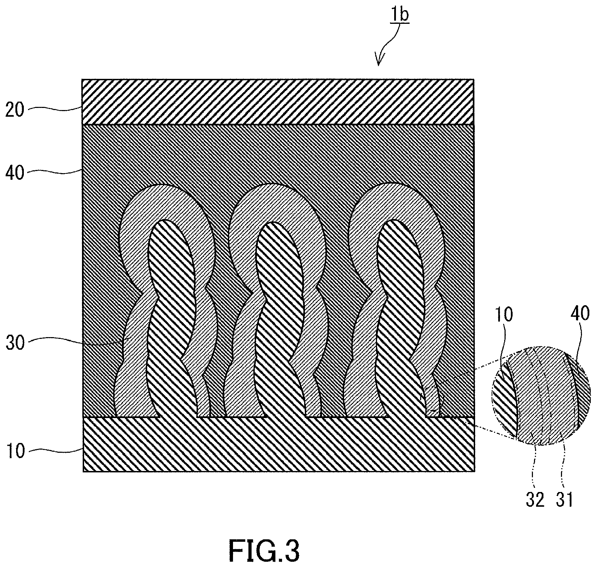

FIG. 3 is a cross-sectional view showing another example of a capacitor of the present disclosure. A capacitor 1b shown in FIG. 3 is configured in the same manner as the capacitor 1a, except for the parts that will be specifically described. The components of the capacitor 1b that are the same as or correspond to the components of the capacitor 1a are given the same reference numerals, and detailed description thereof will be omitted. The description of the capacitor 1a also applies to the capacitor 1b, unless technically inconsistent.

As shown in FIG. 3, in the capacitor 1b, at least a part of the metallic tantalum 10 is porous. According to such a configuration, the surface area of the metallic tantalum 10 is likely to be increased, and thus, the capacitor 1b is likely to have a high capacitance. Such a porous structure can be formed by any process, for example, etching the metallic foil, or sintering a powder.

As shown in FIG. 3, an oxidized tantalum film 30 is disposed on the surface of the porous portion of the metallic tantalum 10. The oxidized tantalum film 30 is formed as described above, for example, by anodization. The electrolyte 40 is disposed to fill voids around the porous portion of the first electrode 10. The electrolyte 40 includes, for example, at least one selected from the group consisting of manganese oxide, an electrolyte solution, and an electrically conductive polymer. Examples of the electrically conductive polymer include polypyrrole, polythiophene, polyaniline, and derivatives thereof. The electrolyte 40 may be a manganese compound such as manganese oxide. The electrolyte 40 may include a solid electrolyte. In the capacitor 1b, for example, a cathode is formed of the electric conductor 20 and the electrolyte 40. The electric conductor 20 may include, for example, a solidified product of silver-containing paste, a carbon material such as graphite, or both the solidified product and the carbon material.

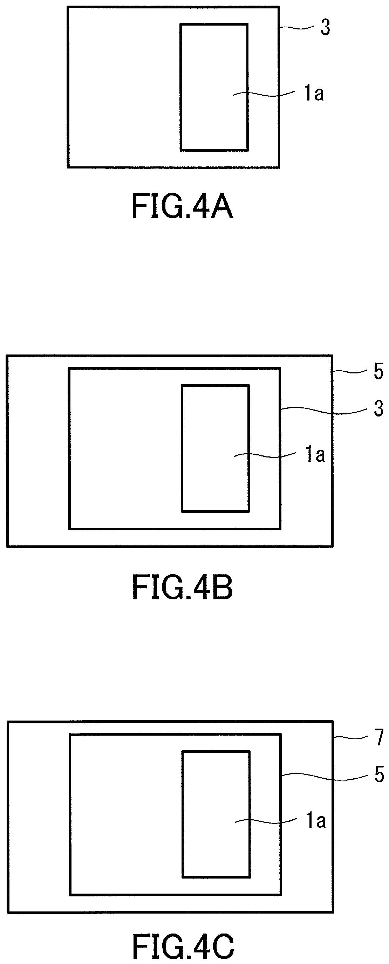

FIG. 4A schematically shows an example of an electric circuit of the present disclosure. An electric circuit 3 includes a capacitor 1a. The electric circuit 3 may be an active circuit, or may be a passive circuit. The electric circuit 3 may be a discharging circuit, may be a smoothing circuit, may be a decoupling circuit, or may be a coupling circuit. Since the electric circuit 3 includes the capacitor 1a, the electric circuit 3 can easily exhibit desired performance. For example, noise is more easily be reduced in the electric circuit 3. The electric circuit 3 may include a capacitor 1b.

FIG. 4B schematically shows an example of a circuit board of the present disclosure. As shown in FIG. 4B, a circuit board 5 includes a capacitor 1a. For example, in the circuit board 5, an electric circuit 3 including the capacitor 1a is formed. The circuit board 5 can easily exhibit desired performance, since the circuit board 5 includes the capacitor 1a. The circuit board 5 may be an embedded board or a motherboard. The circuit board 5 may include the capacitor 1b.

FIG. 4C schematically shows an example of an apparatus of the present disclosure. As shown in FIG. 4C, an apparatus 7 includes the capacitor 1a. The apparatus 7 includes, for example, a circuit board 5 including the capacitor 1a. Since the apparatus 7 includes the capacitor 1a, the apparatus 7 can more easily exhibit desired performance. The apparatus 7 may be an electronic apparatus, may be a communication apparatus, may be a signal processing device, or may be a power-supply device. The apparatus 7 may be a server, an AC adapter, an accelerator, or a flat panel display such as a liquid crystal display (LCD). The apparatus 7 may be a USB charger, a solid-state drive (SSD), an information terminal such as a PC, smartphone, and tablet PC, or an ethernet switch. The apparatus 7 may include a capacitor 1b.

### EXAMPLES

Hereinafter, the present disclosure will be described in detail by referring to Examples. It should be noted that the following Examples are illustrative and the present disclosure is not limited to the Examples.

### <Example 1>

Ultrasonic cleaning was performed for 10 minutes with metallic tantalum immersed in a container filled with acetone to clean the surface of the metallic tantalum. After that, acetone adhering to the surface of the metallic tantalum was evaporated, and the surface of the metallic tantalum was washed with pure water. The metallic tantalum was then dried in air.

The metallic tantalum and a platinum foil as a counter electrode were disposed at predetermined intervals in an aqueous solution containing H₃PO₄. A portion of the metallic tantalum not immersed in the aqueous solution was connected to the positive electrode of a power-supply device, while a portion of the platinum foil not immersed in the aqueous solution was connected to the negative electrode of the power-supply device. A current was applied from the power-supply device in a constant voltage state, so that a voltage of 64 V was applied between the metallic tantalum and the counter electrode for 30 minutes. An electrochemical reaction was made occur on the surface of the metallic tantalum as the anode, whereby an oxidized film was formed. The metallic tantalum with the oxidized film formed was taken out from the aqueous solution, washed with pure water, and dried in air.

Next, the metallic tantalum with the oxidized film formed was disposed as the anode and the platinum foil was disposed as the cathode in the NH₄HF₂ aqueous solution, and the portion of the anode and the portion of the cathode not immersed in the aqueous solution were connected respectively to the positive electrode and to the negative electrode of the power-supply device. The concentration of the NH₄HF₂ in the aqueous solution was 0.5 mol/liter (mol/L). A current was applied from the power-supply device in a constant voltage state, whereby a voltage of 80 V was applied between the anode and the cathode for 10 minutes to perform anodization. The anodized anode was then taken out from the aqueous solution, washed with pure water, and dried. In this manner, a sample according to Example 1 was obtained, in which a dielectric film was formed on the surface of the metallic tantalum.

### <Example 2>

Ultrasonic cleaning was performed for 10 minutes with metallic tantalum immersed in a container filled with acetone, thereby cleaning the surface of the metallic tantalum. After that, acetone adhering to the surface of the metallic tantalum was evaporated, and the surface of the metallic tantalum was washed with pure water. The metallic tantalum was then dried in air.

The metallic tantalum and a platinum foil as a counter electrode were disposed at predetermined intervals in an aqueous solution containing H₃PO₄. A portion of the metallic tantalum not immersed in the aqueous solution was connected to the positive electrode of a power-supply device, while a portion of the platinum foil not immersed in the aqueous solution was connected to the negative electrode of the power-supply device. A current was applied from the power-supply device in a constant voltage state, so that a voltage of 64 V was applied between the metallic tantalum and the counter electrode for 30 minutes. An electrochemical reaction was made occur on the surface of the metallic tantalum as the anode, whereby an oxidized film was formed. The metallic tantalum with the oxidized film formed was taken out from the aqueous solution, washed with pure water, and dried in air.

Next, the metallic tantalum with the oxidized film formed was disposed as the anode and the platinum foil was disposed as the cathode in the NH₄HF₂ aqueous solution, and the portion of the anode and the portion of the cathode not immersed in the aqueous solution were connected respectively to the positive electrode and to the negative electrode of the power-supply device. The concentration of the NH₄HF₂ in the aqueous solution was 1.0 mol/liter (mol/L). A current was applied from the power-supply device in a constant voltage state, whereby a voltage of 80 V was applied between the anode and the cathode for 10 minutes to perform anodization. The anodized anode was then taken out from the aqueous solution, washed with pure water, and dried. In this manner, a sample according to Example 2 was obtained, in which a dielectric film was formed on the surface of the metallic tantalum.

### <Comparative Example 1>

Ultrasonic cleaning was performed for 10 minutes with metallic tantalum immersed in a container filled with acetone, thereby cleaning the surface of the metallic tantalum. After that, acetone adhering to the surface of the metallic tantalum was evaporated, and the surface of the metallic tantalum was washed with pure water. The metallic tantalum was then dried in air.

Next, the metallic tantalum was disposed as the anode and the platinum foil was disposed as the cathode in the NH₄HF₂ aqueous solution, and the portion of the anode and the portion of the cathode not immersed in the aqueous solution were connected respectively to the anode and to the cathode of the power-supply device. The concentration of NH₄HF₂ in the aqueous solution was 0.5 mol/liter (mol/L). A current was applied from a power-supply device in a constant voltage state, whereby a voltage of 80 V was applied between the anode and cathode for 10 minutes to perform anodization. The anode was then taken out from the aqueous solution, washed with pure water, and dried. In this manner, a sample according to Comparative Example 1 was obtained, in which a dielectric film was formed on the surface of the metallic tantalum.

### <Comparative Example 2>

Ultrasonic cleaning was performed for 10 minutes with metallic tantalum immersed in a container filled with acetone, thereby cleaning the surface of the metallic tantalum. After that, acetone adhering to the surface of the metallic tantalum was evaporated, and the surface of the metallic tantalum was washed with pure water. The metallic tantalum was then dried in air.

The metallic tantalum as an anode and a platinum foil as a cathode were disposed at predetermined intervals in an aqueous solution containing H₃PO₄. The portion of the anode and the portion of the cathode not immersed in the aqueous solution were connected respectively to the positive electrode and the negative electrode of the power-supply device. A current was applied from the power-supply device in a constant voltage state, so that a voltage of 80 V was applied between the anode and the cathode for 30 minutes. An electrochemical reaction was made occur on the surface of the metallic tantalum as the anode, whereby an oxidized film as an oxidized film was formed. The metallic tantalum with the oxidized film formed was taken out from the aqueous solution, washed with pure water, and dried in air. In this manner, a sample according to Comparative Example 2, having a dielectric film formed of fluorine-free oxidized tantalum was obtained.

### (X-ray diffraction measurement)

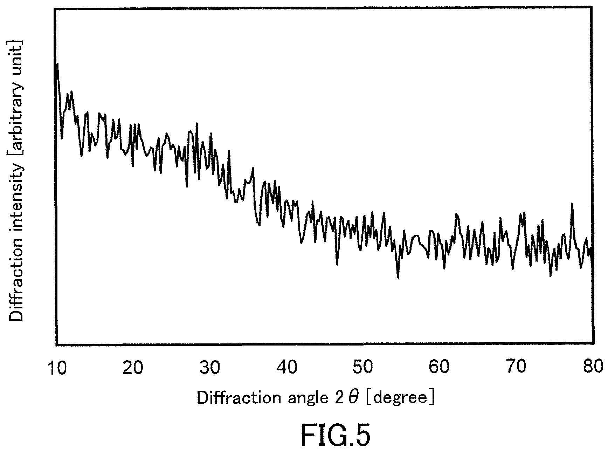

An XRD pattern of the dielectric film of the sample according to Example 1 was obtained by a 2θ/θ scan using an X-ray diffraction (XRD) system Smartlab manufactured by Rigaku Corporation. Cu-Kα radiation was used for the source of X-ray, the voltage was adjusted to 40 kV, the current was adjusted to 30 mA, and the scanning rate was adjusted to 10 deg./min. FIG. 5 shows the XRD pattern of the dielectric film of the sample according to Example 1. Peaks derived from a crystal structure were not confirmed in the XRD pattern shown in FIG. 5, indicating that the oxidized tantalum film of the sample according to Example 1 was amorphous.

### (Elemental composition analysis)

Pelletron 5SDH-2 for Rutherford backscattering spectrometer (RBS) was used to perform RBS on the samples prepared from the surface portions of the dielectric layers of the samples according to Example 1 and Example 2. The RBS spectra were obtained by irradiating the samples with ion beams under the specified requirements in the RBS. According to the obtained RBS spectra, the ratio of the number of fluorine atoms to the number of tantalum atoms on the surface portion of the dielectric layer of the sample for Example 1 was 0.06, and the ratio of the number of fluorine atoms to the number of tantalum atoms on the surface portion of the dielectric layer of the sample for Example 2 was 0.40. According to the obtained RBS spectra, the composition of the surface portion of the dielectric layer of the sample for Example 1 was TaO_{2.47}F_{0.06}, and the composition of the surface portion of the dielectric layer of the sample for Example 2 was TaO_{2.30}F_{0.40}.

### (TOF-SIMS)

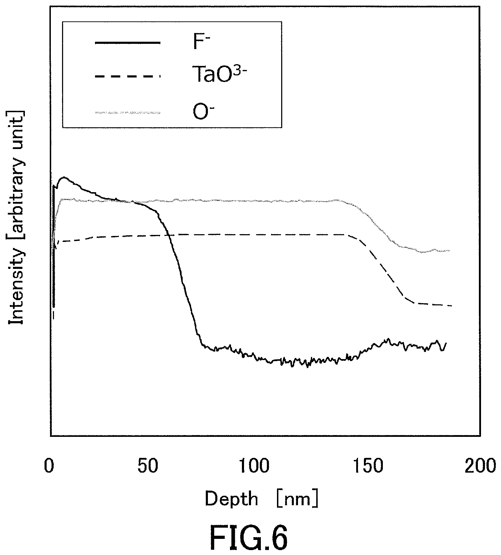

A segment of a specified size was cut from the sample of Example 1 so as to prepare a specimen for TOF-SIMS by resin-embedding. Using a TOF-SIMS device TOF.SIMS5 manufactured by IONTOF GmbH, TOF-SIMS was performed on the specimen prepared from the sample according to Example 1, and a composition analysis was performed in the depth direction of the oxidized film of the dielectric film. In the TOF-SIMS, a Bi beam was used as the primary ion beam, and O₂ was used as the sputtering ion species. FIG. 6 is a graph showing the relation between signal intensity of F⁻, TaO₃⁻, and O⁻ in TOF-SIMS and depth in the dielectric film of the sample according to Example 1. In FIG. 6, the vertical axis shows the signal intensity of each ion and the horizontal axis shows the depth in the dielectric film.

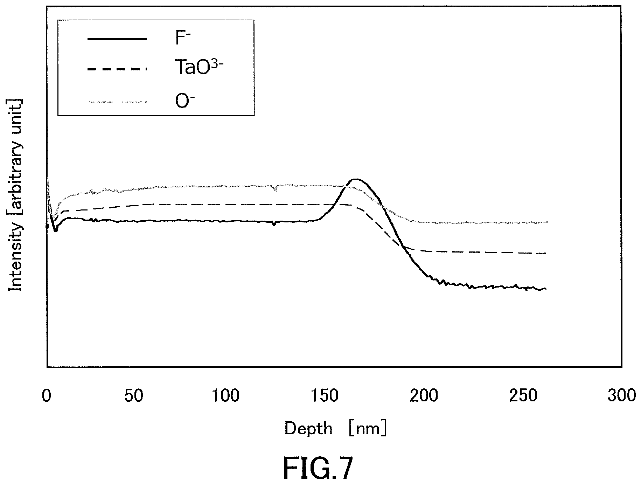

TOF-SIMS was performed on the sample according to Comparative Example 1 in the same manner as in Example 1. FIG. 7 is a graph showing the relation between signal intensity of F⁻, TaO₃⁻, and O⁻ in TOF-SIMS and depth in the dielectric film of the sample according to Comparative Example 1. In FIG. 7, the vertical axis shows the signal intensity of each ion and the horizontal axis shows the depth in the dielectric film.

It is understood from FIG. 6 that the dielectric film of the sample according to Example 1 is formed on the metallic tantalum and the dielectric film includes a portion with high fluorine concentration and a portion with low fluorine concentration. The portion with high fluorine concentration is present from the surface of the dielectric film to a depth of about 60 nm. On the other hand, the portion with low fluorine concentration is present from a depth of about 75 nm to a depth of about 150 nm in the dielectric film. The F⁻ signal intensity in the low fluorine concentration portion of the dielectric film indicates that the fluorine concentration at this portion is 0.5% or less on the basis of the number of atoms. The fluctuation in fluorine concentration is small in both the portion with high fluorine concentration and the portion with low fluorine concentration. A ratio of R_{F2} to R_{F1} was about 0.1 where R_{F1} is the F⁻ signal intensity of the TOF-SIMS at a portion of the oxidized tantalum film 30 where the fluorine concentration is high while the R_{F2} is the F⁻ signal intensity of the TOF-SIMS at a portion of the oxidized tantalum film 30 where the fluorine concentration is low. In FIG. 6, the depth of about 150 nm or more is understood to correspond to the metallic tantalum. No increase in the fluorine concentration is observed at the boundary between the metallic tantalum and the dielectric film.

In the meantime, it is understood from FIG. 7 that the dielectric film in the sample of Comparative Example 1 is present from its surface to a depth of about 180 nm. In the sample according to Comparative Example 1, an increase in the fluorine concentration is observed at the boundary between the metallic tantalum and the dielectric film. The reason is considered as follows. Since the diffusion rate of fluoride ions is much greater than that of oxide ions, diffusion of fluoride ions into the metallic tantalum and generation of tantalum fluoride occur prior to the formation of an oxidized tantalum film by anodization. The tantalum fluoride thus formed has a poor electrical insulation property and may degrade the dielectric properties required for capacitors. Another concern is that the presence of such tantalum fluoride in the vicinity of the metallic tantalum may cause uneven formation of the oxidized tantalum film, resulting in delamination of the oxidized tantalum film. Therefore, dielectrics in which tantalum fluoride is present in the vicinity of the metallic tantalum are not suitable as dielectrics for capacitors. On the other hand, if a chemical conversion treatment using a solution free of fluorine is performed in advance, as in Example 1, an oxidized tantalum film containing fluorine can be easily formed on the metallic tantalum, without delamination.

### (Capacitance and dielectric loss tangent)

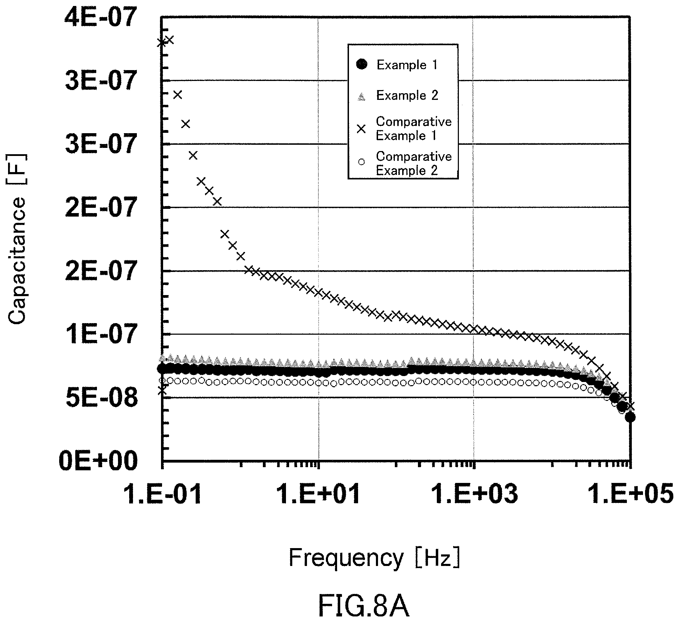

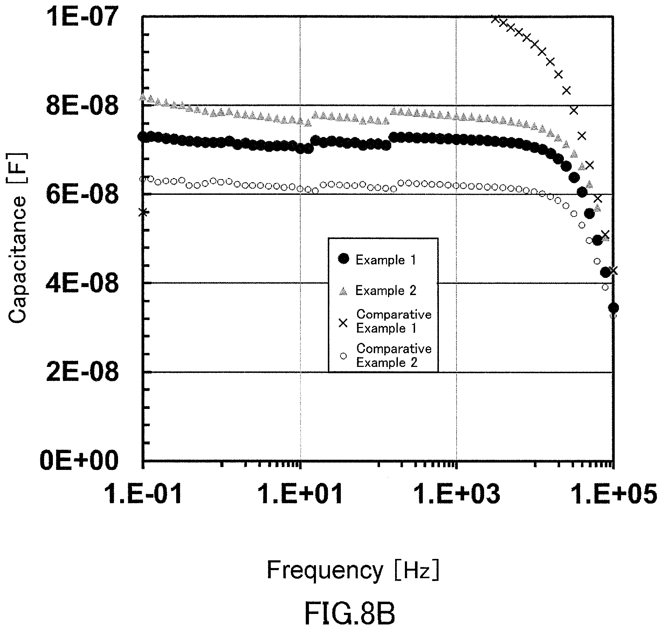

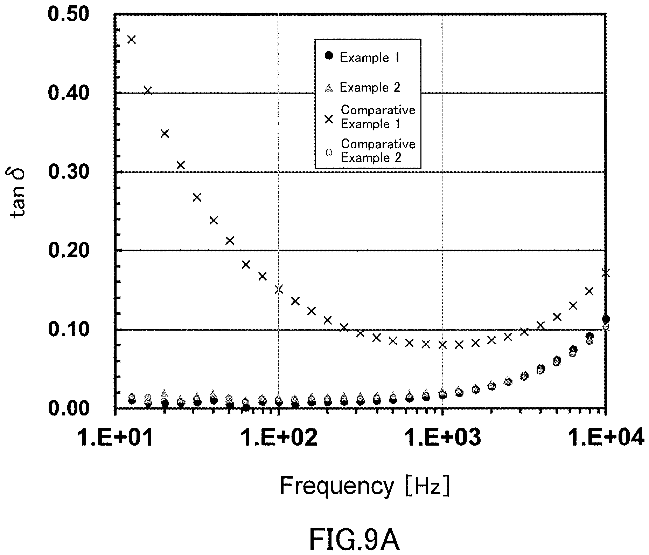

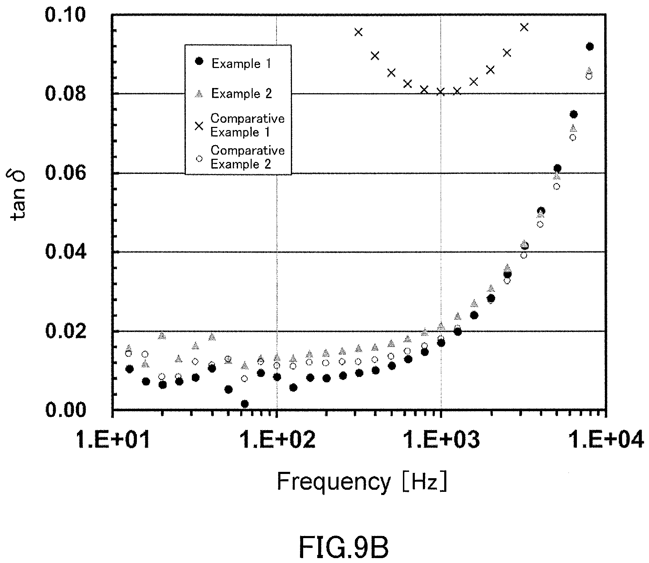

The sample of Example 1 was attached to an electrochemical cell manufactured by BAS Inc., and the dielectric properties of the capacitor of Example 1 were evaluated according to the AC impedance method using platinum as the counter electrode. In this evaluation, an AC voltage was applied to the capacitor in the range of 10 to 100 mV amplitude and 1 MHz to 0.1 Hz, and the capacitance was calculated from the resistance value at each frequency. FIG. 8A and FIG. 8B are graphs showing a relation between capacitance and frequency of a capacitor. In FIG. 8A and FIG. 8B, the vertical axis shows the capacitance and the horizontal axis shows the frequency. FIG. 8B shows an enlarged portion of FIG. 8A. In addition, based on the results of this evaluation, the dielectric loss tangent tanδ was obtained at each frequency for the capacitor according to Example 1. FIG. 9A and FIG. 9B are graphs showing the relationship between the dielectric loss tangent tanδ of the capacitor and frequency. In FIG. 9A, the vertical axis shows tanδ and the horizontal axis shows frequency. FIG. 9B shows an enlarged portion of FIG. 9A.

The sample for Example 2 was attached to an electrochemical cell manufactured by BAS Inc., and the capacitance and dielectric loss tangent tanδ of the capacitor for Example 2 were calculated in the same manner as for Example 1, according to the AC impedance method using platinum as the counter electrode. The results are shown in FIG. 8A to FIG. 9B.

The sample of Comparative Example 1 was attached to an electrochemical cell manufactured by BAS Inc., and the capacitance and dielectric loss tangent tanδ of the capacitor of Comparative Example 1 were calculated in the same manner as in Example 1, according to the AC impedance method using platinum as the counter electrode. The results are shown in FIG. 8A to FIG. 9B.

The sample according to Comparative Example 2 was attached to an electrochemical cell manufactured by BAS Inc., and the capacitance and dielectric loss tangent tanδ of the capacitor according to Comparative Example 2 were determined in the same manner as in Example 1 according to the AC impedance method using platinum as the counter electrode. The results are shown in FIG. 8A to FIG. 9B.

The dielectric layers of the samples according to Example 1, Example 2, Comparative Example 1, and Comparative Example 2 are formed on metallic tantalum with equivalent surface conditions, and it is understood that there is no significant difference in the surface area of the dielectric layers of the samples. FIG. 8A and FIG. 8B show that the capacitance of the capacitors for Example 1, Example 2, and Comparative Example 1 is higher than the capacitance of the capacitor for Comparative Example 2. Although the capacitance of the capacitor in Comparative Example 1 is high, the dielectric loss tangent tanδ of the capacitor according to Comparative Example 1 is high as shown in FIG. 9A and FIG. 9B. The tanδ corresponds to the energy consumed inside the capacitor, and this indicates that the capacitor according to Comparative Example 1 suffers from a large loss of electrical energy. In contrast, the dielectric loss tangents tanδ of the capacitors according to Examples 1 and 2 are low and remain at values substantially equivalent to the dielectric loss tangent of the capacitor according to Comparative Example 2. Therefore, it is understood as a whole that the capacitors according to Examples 1 and 2 are superior not only from the viewpoint of capacitance but also from the viewpoint of reducing loss of electrical energy.

### INDUSTRIAL APPLICABILITY

The capacitor according to the present disclosure is advantageous from the viewpoint of reducing the dielectric loss tangent.

## Claims

1. A capacitor comprising:
metallic tantalum;
an electric conductor; and
an oxidized tantalum film disposed between the metallic tantalum and the electric conductor, the oxidized tantalum film being in contact with the metallic tantalum, wherein
the oxidized tantalum film includes a first portion containing fluorine and a second portion located closer to the metallic tantalum than the first portion in a thickness direction of the oxidized tantalum film, and
a fluorine concentration at the second portion is lower than a fluorine concentration at the first portion.

2. The capacitor according to claim 1, wherein
the first portion is amorphous.

3. The capacitor according to claim 1, wherein
the first portion has a composition represented by TaOₓF_{y}, and the composition satisfies a requirement 0 < x < 2.5.

4. The capacitor according to claim 3, wherein
the composition further satisfies a requirement y ≥ 0.015.

5. The capacitor according to claim 4, wherein
the composition further satisfies a requirement y ≤ 0.40.

6. The capacitor according to claim 1, wherein
the fluorine concentration at the second portion is 0.4% or less on the basis of the number of atoms.

7. The capacitor according to claim 1, wherein
the second portion has a thickness of more than 5 nm and not more than 100 nm.

8. The capacitor according to claim 1, further comprising an electrolyte disposed between the oxidized tantalum film and the electric conductor.

9. An electric circuit comprising the capacitor according to any one of claims 1 to 8.

10. A circuit board comprising the capacitor according to any one of claims 1 to 8.

11. An apparatus comprising the capacitor according to any one of claims 1 to 8.

12. A method for manufacturing a capacitor, the method comprising:
anodizing metallic tantalum in contact with a fluorine-free aqueous solution to form a tantalum oxide layer on the metallic tantalum; and
anodizing the tantalum oxide layer in contact with a fluorine-containing aqueous solution to form a fluorine-containing oxidized tantalum film on a surface region of the tantalum oxide layer.
